# EUROPÄISCHE PATENTSCHRIFT

(11) **EP 2 063 432 B1**
(45) Veröffentlichungstag und Bekanntmachung des Hinweises auf die Patenterteilung: **29.08.2012**
(21) Anmeldenummer: 07075997.2
(22) Anmeldetag: 15.11.2007
(51) Int. Cl.: G06F 11/10, G11C 29/02, G11C 29/12

(54) **Verfahren zum Prüfen eines Arbeitsspeichers**
Method for testing a working memory
Procédé destiné à vérifier une mémoire de travail

(43) Veröffentlichungstag der Anmeldung: 27.05.2009
(73) Patentinhaber: Grundfos Management A/S, 8850 Bjerringbro (DK)
(72) Erfinder: Bomholt, John, 8382 Hinnerup (DK); Hedegaard, Flemming, 8850 Bjerringbro (DK); Skjellerup, Jorn, 8850 Bjerringbro (DK); Strom, Niels Jorgen, 8383 Hinnerup (DK)
(74) Vertreter: Vollmann, Heiko

(56) Entgegenhaltungen:
- US-A- 5 461 588
- US-A1- 2006 129 899
- US-A1- 2006 203 599
- US-A1- 2007 002 649
- US-A1- 2007 061 668

## Beschreibung

Die Erfindung betrifft ein Verfahren zum Prüfen eines Arbeitsspeichers, insbesondere des Arbeitsspeichers der Steuer- und Regelelektronik eines Frequenzumrichters, der eine Matrix von Speicherzellen, Mittel zum Adressieren der Speicherzellenmatrix und einen Schalt-/Leseschaltkreis aufweist.

Derartige Arbeitsspeicher zählen zum Stand der Technik und sind in nahezu jeder digitalen Elektronik zu finden. Es handelt sich dabei um Halbleiterspeicher, z. B. Ram-Chips, die neben der eigentlichen Matrix von Speicherzellen einen Adresscodierer zum Adressieren der Zellen mittels eines Adressbuses sowie einen Schalt-/Leseschaltkreis zum Schreiben und Lesen der Daten mittels eines Datenbuses aufweisen. Sowohl hinsichtlich der Adressierung als auch hinsichtlich der Zellmatrix selbst können schon kleinste Veränderungen, insbesondere Verunreinigungen im Chip, Temperaturschwankungen und dergleichen zu Fehlern führen. Es zählt daher zum Stand der Technik, beim Einschalten bzw. Hochfahren des jeweiligen mit einem solchen Arbeitsspeicher bestückten Gerätes diesen meist zu Beginn mittels eines Selbsttests vollständig zu überprüfen, und zwar sowohl hinsichtlich der einwandfreien Funktion des Adresscodierers und des Adressbuses als auch hinsichtlich der einwandfreien Funktion der einzelnen Speicherzellen. Diese Überprüfung erfolgt beim Stand der Technik typischerweise in einem einheitlichen durchlaufenden Test, in dem beide Funktionen verknüpft und somit zusammen überprüft werden. Derartige Testverfahren sind hinlänglich bekannt, so z. B. der March-X-Test.

Die bekannten Testverfahren haben jedoch den Nachteil, dass sie vergleichsweise zeitintensiv sind und aufgrund ihrer Struktur bedingen, dass der gesamte zu prüfende Arbeitsspeicher während des Tests nicht nutzbar ist.

Es gibt jedoch zahlreiche Anwendungen, bei denen ein solch anfänglicher Speichertest nach Einschalten nicht ausreicht, um die Betriebssicherheit des mit dem Speicher arbeitenden Gerätes ausreichend sicherzustellen. Dies ist z. B. bei Servern der Fall, die nie abgeschaltet werden, aber auch bei digitalen Schaltungen für Motoren und dergleichen, die über lange Zeit ununterbrochen laufen. Insoweit zählt es aus US 5,461,588 oder aus US 2006/0129899 zum Stand der Technik, einen zusätzlichen Hilfsspeicher vorzusehen, in dem die Daten abgespeichert werden können, die in dem Teil des Arbeitsspeichers befindlich sind, der gerade überprüft werden soll. Das dort beschriebene Verfahren ist jedoch für einen Speichertest während des Betriebs des Speichers nur bedingt tauglich, da die Daten zwar während des Tests im Hilfsspeicher zwischengespeichert und nachfolgend wieder in den Arbeitsspeicher geschrieben werden, doch im Falle einer Änderung dieser Daten Probleme auftreten können. Darüber hinaus bedingt dies zusätzlichen, sonst nicht nutzbaren Arbeitsspeicher sowie entsprechende Controllerleistung, um diese Zwischenspeicherung und Rückspeicherung der Daten durchzuführen.

Vor diesem Stand der Technik liegt der vorliegenden Erfindung die Aufgabe zugrunde, ein Verfahren zum Prüfen eines Arbeitsspeichers zu schaffen, das den Controller nur möglichst kurz und von der Rechenleistung möglichst wenig belastet, so dass dies auch im laufenden Betrieb durchgeführt werden kann. Des Weiteren soll ein Verfahren insbesondere zum Prüfen des Arbeitsspeichers der Steuer- und Regelelektronik eines Frequenzumrichters geschaffen werden, das eine Überprüfung des Arbeitsspeichers während des Betriebs ermöglicht, um so den Arbeitsspeicher in sicherheitsrelevante Funktionen einbinden zu können.

Diese Aufgabe wird gemäß der Erfindung durch die in Anspruch 1 angegebenen Merkmale gelöst. Vorteilhafte Ausgestaltungen des Verfahrens sind in den Unteransprüchen, der nachfolgenden Beschreibung und der Zeichnung angegeben.

Das erfindungsgemäße Verfahren zum Prüfen eines Arbeitsspeichers, insbesondere des Arbeitsspeichers der Steuer- und Regelelektronik eines Frequenzumrichters, der eine Matrix von Speicherzellen, Mittel zum Adressieren der Speicherzellenmatrix und einen Schalt-/Leseschaltkreis aufweist, überprüft in einem Schritt zumindest einen Teil der Mittel zum Adressieren auf Adressfehler hin und in einem anderen Schritt zumindest einen Teil der Speicherzellen auf Zellfehler hin, wobei die Prüfschritte zeitlich unabhängig voneinander erfolgen.

Unter Mitteln zum Adressieren der Speicherzellenmatrix im Sinne der Erfindung ist all das zu verstehen, welches zwischen Controller und Speicherzellenmatrix erforderlich ist, um die notwendige Adressierung vorzunehmen. Hierzu zählt typischerweise der Adressbus, dessen Leitungen z. B. über Transistoren angesteuert werden und damit auf 1 oder 0 gesetzt werden können, sowie z. B. ein Adresscodierer und dergleichen. Die in diesem Bereich möglicherweise auftretenden Fehler sollen mit dem einen Schritt überprüft werden, wohingegen mit dem anderen Schritt die Speicherzellen selbst überprüft werden sollen.

Grundgedanke des erfindungsgemäßen Verfahrens ist es somit, den Speichertest in einzelnen Schritten durchzuführen, die zeitlich voneinander unabhängig sind, so dass diese auch während des laufenden Betriebs durchgeführt werden können, wenn z. B. Teile des Arbeitsspeichers gerade nicht benötigt werden oder aus sonstigen Gründen zur Überprüfung zur Verfügung stehen. Dabei sieht das erfindungsgemäße Verfahren grundsätzlich zwei voneinander sowohl zeitlich als auch in der Reihenfolge voneinander unabhängige Prüfschritte vor. Dabei ist eine Aufteilung der Überprüfung dahingehend vorgesehen, dass eine Überprüfung der Mittel zum Adressieren, z. b. des Adressbuses und des Adresscodierers auf Adressfehler hin erfolgt sowie eine Überprüfung der Speicherzellen auf Zellfehler hin. Beide Prüfungen können abschnittsweise mit Unterbrechung oder vollständig nacheinander oder auch abschnittsweise nacheinander erfolgen, je nach technischer Anwendung und Bedürfnissen.

Es hat sich erstaunlicherweise gezeigt, dass die erfindungsgemäße Durchführung der Arbeitsspeicherprüfung in den vorgenannten Teilprüfschritten nicht nur für den jeweiligen Teilprüfschritt, sondern auch für die Summe der Prüfschritte eine deutlich geringere Prüfzeit erfordert, als dies bei Prüfverfahren nach dem Stand der Technik erforderlich ist, wenn Adressbus/-codierer und Speicherzellen in einem zusammenhängenden Test auf Fehler geprüft werden.

Vorteilhaft kann nach dem Überprüfen eines Teils des Adressbuses/- codierers auf Adressfehler ein Teil der Speicherzellen auf Zellfehler überprüft werden, wonach ein weiterer Teil des Adressbuses/-codierers auf Adressfehler und dann der weitere Teil der Speicherzellen auf Zellfehler usw. überprüft wird. Dabei müssen die nacheinander überprüften Teile des Adressbuses/-codierers und der Speicherzellen nicht notwendig übereinstimmen.

Alternativ kann gemäß der Erfindung auch zunächst der Adressbus/- codierer auf Adressfehler und nachfolgend die Speicherzellen auf Zellfehler hin überprüft werden und dies zeitlich unabhängig voneinander, wobei sowohl die Überprüfung des Adressbuses/-codierers als auch die Überprüfung der Speicherzellen nicht zusammenhängend, sondern jeweils bei Bedarf in Teilschritten erfolgen können.

Vorteilhaft wird das erfindungsgemäße Verfahren zum Prüfen des Arbeitsspeichers in vorbestimmten zeitlichen Abständen wiederholt, so dass ein so quasi ständig überprüfter Arbeitsspeicher auch für sicherheitsrelevante Bauteile oder Baugruppen eingesetzt werden kann.

Wenn, was mit dem erfindungsgemäßen Verfahren vorteilhaft möglich ist, die Prüfung des Arbeitsspeichers während des Betriebs der mit dem Speicher arbeitenden Einrichtung, insbesondere des Frequenzumrichters ausgeführt wird, dann ist es besonders zweckmäßig, wenn der das Verfahren ausführende Controller dann für andere Operationen der Einrichtung nicht benötigt oder vermindert benötigt wird und für das Prüfverfahren freie Kapazitäten hat, d. h. dass mittels des Controllers, der das Prüfverfahren steuert, dieses nur dann durchgeführt wird, wenn controllerseitig genügend Rechenkapazität zur Verfügung steht, d. h. der normale Betrieb der Einrichtung dadurch nicht behindert wird. Eine solche, controllerlastabhängige Steuerung des Verfahrens wird vorteilhaft im Controller implementiert. Das erfindungsgemäße Verfahren kann in jedem Verfahrensschritt oder Teilschritt zeitweise unterbrochen und anschließend fortgesetzt werden, was ebenfalls durch den Controller selbst vorteilhaft gesteuert wird.

Erfindungsgemäß werden bei dem einen Schritt des Prüfverfahrens, bei welchem der Adressbus/-codierer auf Adressfehler überprüft wird, so genannte Stuck-at-Fehler (stuck-at-faults) und/oder so genannte Coupling-Fehler (coupling-faults) ermittelt. Bei ersteren wird überprüft, ob die Adressierbarkeit, wie sie üblicherweise mittels eines Adressbuses erfolgt, mittels des Adresscodierers so umgesetzt wird, dass die adressierten Speicherzellen bzw. Speicherbereiche, typischerweise Speicherzeilen, angesprochen, d. h. beschrieben und gelesen werden können.

Bei Ermittlung der Coupling-Adressfehler wird überprüft, ob die Übertragung mittels des Adressbuses und die Umsetzung mittels des Adresscodierer eindeutig ist.

Vorteilhaft wird gemäß der Erfindung zur Ermittlung von Stuck-at-Adressfehlern nicht jede mögliche Speicheradresse überprüft. Es reicht vielmehr aus, den Test, der nachfolgend beschrieben wird, für jedes Adressbit der n-Bits des Adressbuses vorzunehmen, um eine vollständige Überprüfung auf Stuck-at-Adressfehler durchzuführen. Wenn der Adressbus also beispielsweise acht Adressleitungen aufweist, die jeweils einen Spannungszustand "low" oder "high" für 0 oder 1 aufweisen können, so handelt es sich um einen 8-Bit-Adressbus mit dem 2⁸ Speicheradressen definiert werden können.

Zur Ermittlung eines Stuck-at-Adressfehlers wird ein Adressbit dieser acht Bits des Adressbuses auf 1 gesetzt und nach diesem Adressieren über den Datenbus ein Bitmuster in die durch die Adressierung angesprochene Speicherzeile geschrieben. Danach wird dasselbe Adressbit der acht Bits des Adressbuses auf 0 gesetzt und wiederum ein Bitmuster, jedoch ein von dem zuvor gespeicherten unterschiedliches Bitmusters in die durch die Adressierung angesprochene Speicherzeile geschrieben. Dabei werden die übrigen Adressbits unverändert belassen. Es werden dann die beiden zuvor beschriebenen Speicherzeilen ausgelesen und auf Übereinstimmung mit den zuvor geschriebenen Bitmustern überprüft. Wird eine solche Übereinstimmung festgestellt, so liegt ein Stuck-at-Adressfehler bei all den Speicheradressen nicht vor, die sich lediglich hinsichtlich des geänderten Adressbits unterscheiden.

Um eine vollständige Überprüfung aller Speicheradressen auf mögliche Stuck-at-Adressfehler durchzuführen, wird gemäß der Erfindung für jedes der n-Bits des Adressbuses, also im vorstehenden Beispiel für jedes der ach Bits der vorbeschriebene Test durchgeführt. Dabei ist es besonders vorteilhaft und einfach, wenn das in die jeweilige Speicherzeile geschriebene Bitmuster die binäre Adresse der zugehörigen Speicherzeile beinhaltet oder dieser entspricht. Gleichwohl kann bei diesem Test auch jedes andere beliebige Bitmuster eingesetzt werden. Wesentlich ist nur, dass sich die Bitmuster desselben zu überprüfenden Adressbits unterscheiden.

Es versteht sich, dass das vorbeschriebene Verfahren zur Ermittlung von Stuck-at-Adressfehlern nicht zwingend in einem ununterbrochenen Testzyklus erfolgen muss, sondern dass z. B. in einem ersten Schritt die ersten beiden Adressbits, in einem zweiten Schritt das zweite und dritte Adressbit und in einem dritten Schritt z. B. das fünfte Adressbit sowie in einem weiteren Schritt die sechsten bis achten Adressbits überprüft werden können.

Unabhängig von der Ermittlung von Stuck-at-Adressfehlern kann bei der Überprüfung des Adressbuses/-codierers die Ermittlung von Coupling-Adressfehlern erfolgen. Hierzu sieht das erfindungsgemäße Verfahren vorteilhaft vor, dass nacheinander jeweils zwei Bits der n-Bits des Adressbuses des Speichers auf 0, auf 1 und auf 0 und 1 bzw. 1 und 0 gesetzt werden, wobei vorzugsweise der Zustand der übrigen Bits unverändert bleibt, was jedoch für das Verfahren selbst nicht erforderlich, sondern lediglich vorteilhaft ist. Nach jedem wie vorbeschriebenen Setzen einer Speicheradresse wird ein Bitmuster in die durch die jeweilige Adressierung angesprochene Speicherzeile geschrieben. Die Bitmuster müssen sich dabei voneinander unterscheiden. Es werden dann schließlich nach dem Schreiben der drei Bitmuster diese ausgelesen und mit den zuvor geschriebenen Bitmustern auf Übereinstimmung überprüft. Liegt eine Übereinstimmung vor, dann ist der Adressbus/- codierer insoweit in Ordnung, d. h. ein Coupling-Adressfehler liegt zumindest hinsichtlich der geprüften Bits des Adressbuses nicht vor.

Um den Adressbus/-codierer vollständig auf Coupling-Adressfehler zu überprüfen, ist es erforderlich, jedes Bit des n-Bit-Adressbuses mit jedem der übrigen Bits nach dem vorstehenden Schema zu setzen, mit unterschiedlichen Bitmustern zu beschreiben und nachfolgend auf Übereinstimmung mit den gelesenen Bitmustern zu überprüfen.

Auch bei diesem Verfahren ist es vorteilhaft, wenn das in die jeweilige Zeile geschriebene Bitmuster die zugehörige binäre Adresse beinhaltet oder dieser entspricht. Auch bei diesem Verfahren spielt es ersichtlich keine Rolle, ob die Überprüfung von Coupling-Adressfehlern in einem Durchgang vollständig oder in mehreren Durchgängen schrittweise erfolgt. Eine Unterbrechung des Prüfverfahrens ist ohne Probleme möglich.

Unabhängig davon sieht das erfindungsgemäße Verfahren die Zellfehlerermittlung vor, d. h. die Überprüfung der Speicherzellen selbst. Da, wie vorbeschrieben, die Adressierung zeilenweise erfolgt, erfolgt die Überprüfung der Speicherzellen selbst ebenfalls zeilenweise. Dabei werden gemäß einem ersten Verfahren der Erfindung benachbarte Speicherzellen einer Speicherzeile abwechselnd mit 0 und 1 beschrieben, wonach die Zeile ausgelesen und auf Übereinstimmung mit der zuvor geschriebenen Zeile überprüft wird. Danach erfolgt eine Beschreibung derselben Speicherzeile, aber in umgekehrter Weise, indem nämlich benachbarte Speicherzellen der Speicherzeile abwechselnd mit 1 und 0 beschrieben werden. Es erfolgt ebenfalls eine Auslesung der Zeile und Überprüfung mit den zuvor geschriebenen Werten. Wenn in beiden Fällen Übereinstimmung festgestellt wird, so sind die Zellen der überprüften Speicherzeile in Ordnung. Es ist somit jede Zelle dieser Speicherzeile einmal mit dem Zustand 1 und einmal mit dem Zustand 0 getestet worden, wobei die Nachbarzelle jeweils den entgegengesetzten Zustand aufweist.

Alternativ sieht die Erfindung vor, eine Zellfehlerüberprüfung so durchzuführen, dass nacheinander jede einzelne Speicherzelle einer Speicherzeile mit 1 und die übrigen Speicherzellen mit 0 beschrieben, ausgelesen und überprüft werden. Dieses Verfahren testet somit zeilenweise Zelle für Zelle, wobei jede Zeile entsprechend der Anzahl der Zellen mehrfach beschrieben, ausgelesen und überprüft werden muss.

Es versteht sich, dass zur Durchführung des erfindungsgemäßen Verfahrens mittels des Controllers im Controller entsprechende Mittel für die Adressierung, das Beschreiben der jeweils adressierten Speicherzeile, das Auslesen der jeweils adressierten Speicherzeile, das Ab- bzw. Zwischenspeichern von ein oder mehreren Speicherzeilen sowie Mittel zum Vergleichen der Bitmuster vorgesehen sind.

Bei den vorstehenden Ausführungen, bei welchen ein Bitwert mit 0 oder 1 angegeben ist, können diese auch umgekehrt, also mit 1 oder 0 angegeben werden, ohne das Verfahren oder Verfahrensschritte grundsätzlich zu verändern.

Das erfindungsgemäße Verfahren wird vorteilhaft in Controller implementiert, sodass es in vorbestimmten Zeitabständen selbsttätig auch während des Betriebs ausgeführt werden kann. Ein besonders vorteilhaftes Anwendungsbeispiel ist die Steuer- und Regelelektronik eines Frequenumrichters, der den Motor einer Kreiselpumpe antreibt, wie Sie beispielsweise in Heizungsanlagen als Umwälzpumpen, in Wasserversorgungsanlagen, in Abwasseranlagen und dergleichen eingesetzt werden. Durch die selbsttätige Überprüfung des Arbeitsspeichers der Steuer- und Regelelektronik kann ein solches Pumpenaggregat erhöhten Sicherheitsanforderungen genügen und somit auch in sicherheitskritischen Bereichen eingesetzt werden.

Das erfindungsgemäße Verfahren ist nachfolgend anhand konkreter Verfahrensschritte zur Ermittlung von Fehlern des Adresscodierer und von Fehlern in der Matrix von Speicherzellen beispielhaft beschrieben.

### Es zeigen:

- Fig. 1: in schematischer Darstellung das Verfahren zur Überprüfung des Adressbuses/-codierers auf Stuck-at-Adressfehler,
- Fig. 2: in Darstellung gemäß Fig. 1 das Verfahren zur Überprüfung des Adressbuses/-codierers auf Coupling-Adressfehler,
- Fig. 3: zwei Bitmuster eines ersten Verfahrens zur Überprüfung der Speicherzellen und
- Fig. 4: zwei Bitmuster eines zweiten Verfahrens zur zeilenweisen Überprüfung von Speicherzellen.

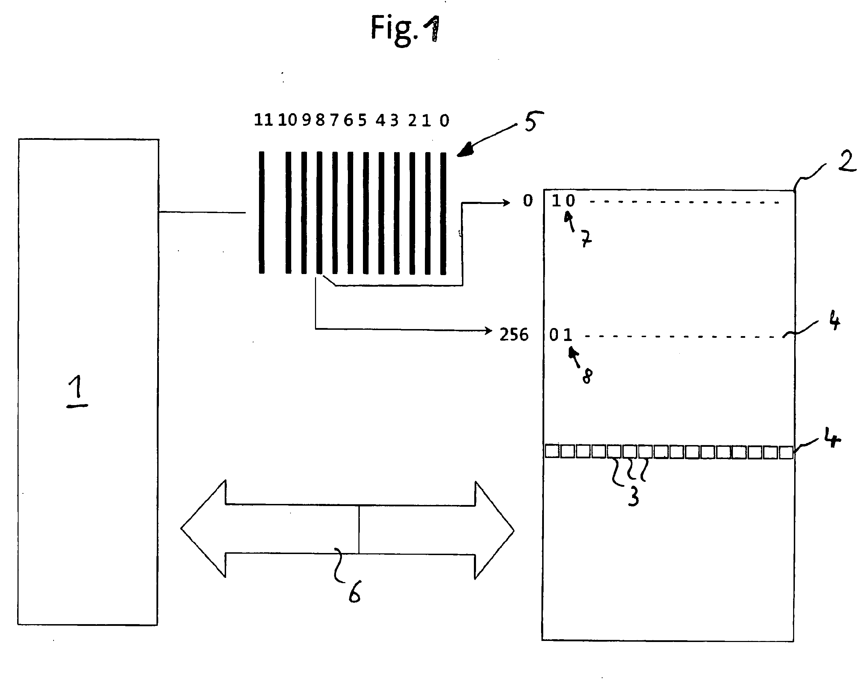

In Fig. 1 ist ein Controller 1 als Teil einer beliebigen digitalen Recheneinheit, z. B. eines Mikroprozessors dargestellt. Der von dem Controller 1 angesteuerte Arbeitsspeicher weist eine Matrix 2 von Speicherzellen 3 auf, die jeweils in Zeilen 4 adressierbar und beschrieben bzw. gelesen werden können. Hierzu ist ein in den Zeichnungen nicht dargestellter Schreib-/Leseschaltkreis vorgesehen sowie ein ebenfalls nicht dargestellter Adresscodierer.

Der Adresscodierer setzt die vom Controller 1 über einen Adressbus 5 gesetzte Adressierung in entsprechende Zeilen 4 der Speicherzellenmatrix 2 um, d. h. über den Adresscodierer werden die vom Controller 1 angewählten Adressen, d. h. Zeilen 4 der Speicherzellenmatrix 2 angesprochen und für das zeilenweise Beschreiben über einen ebenfalls vom Controller 1 beaufschlagten Datenbus 6 oder das zeilenweise Auslesen von Daten geschaltet.

Im dargestellten Ausführungsbeispiel hat der Adressbus 5 eine Datenbreite von 12 Bit, d. h. er weist zwölf Datenleitungen auf, die ein hohes oder ein niedriges Spannungspotential für den Wert 1 bzw. den Wert 0 führen können. Dieser 12-Bit-Adressbus kann somit 2¹², d. h. 4.096 unterschiedliche Adressen ansprechen. Die aus Speicherzellen 3 aufgebaute Matrix weist eine Datenbreite von 16 Bit auf. Sie ist zeilenweise adressierbar und wird über den Datenbus 6 mit entsprechender Datenbreite von 16 Bit angesprochen.

Um die Mittel zum Adressieren, also insbesondere den Adressbus und den Adresscodierer hinsichtlich möglicher Adressfehler (stuck-at-faults) zu überprüfen, werden mittels des Controllers 1 im Ausführungsbeispiel gemäß Fig. 1 beispielhaft zwei Adressen angesprochen, die sich in ihrer Adressierung lediglich in dem Bit Nr. 8 von den insgesamt zwölf Bits, die über den Adressbus 5 parallel übertragen werden, unterscheiden. Es wird also zur Überprüfung dieses Bit Nr. 8 zunächst die Adresse 000000000000 angewählt und in die dadurch definierte Zeile 0 der Speicherzellenmatrix 2 ein Bitmuster 7 über den Datenbus 6 geschrieben, welches im Ausführungsbeispiel gemäß Fig. 1 beispielhaft in den ersten beiden Stellen mit 1 0 angegeben ist. Es wird sodann die Adressierung geändert, aber nur in diesem Bit Nr. 8, was von 0 auf 1 gesetzt wird. Hierdurch ergibt sich die Adresse 256. In die entsprechende Zeile 4 wird ein sich von dem vorgenannten Bitmuster 7 unterscheidendes Bitmuster 8 geschrieben, dessen erste beiden Stellen im Ausführungsbeispiel mit 0 1 angegeben sind.

Es werden dann nachfolgend die zuvor für den Schreibvorgang angewählten Adressen über den Adressbus 5 dem Adresscodierer zugeführt und die entsprechenden Zeilen 0 bzw. 256 aus der Speicherzellenmatrix 2 über den Datenbus 6 ausgelesen und innerhalb des Controllers 1 mit den zuvor dort beschriebenen Bitmustern 7 und 8 verglichen. Wenn eine Übereinstimmung festgestellt wird, ist der Test hinsichtlich des achten Bits (Bit Nr. 8) erfolgreich. Dieser Test wird nun in analoger Weise für die übrigen Adressbits 0 bis 7 und 9-11 wiederholt. Wenn diese Tests abgeschlossen sind und kein Fehler ermittelt werden konnte, dann arbeitet der Adressbus und -codierer hinsichtlich Stuck-at-Adressfehlern fehlerfrei.

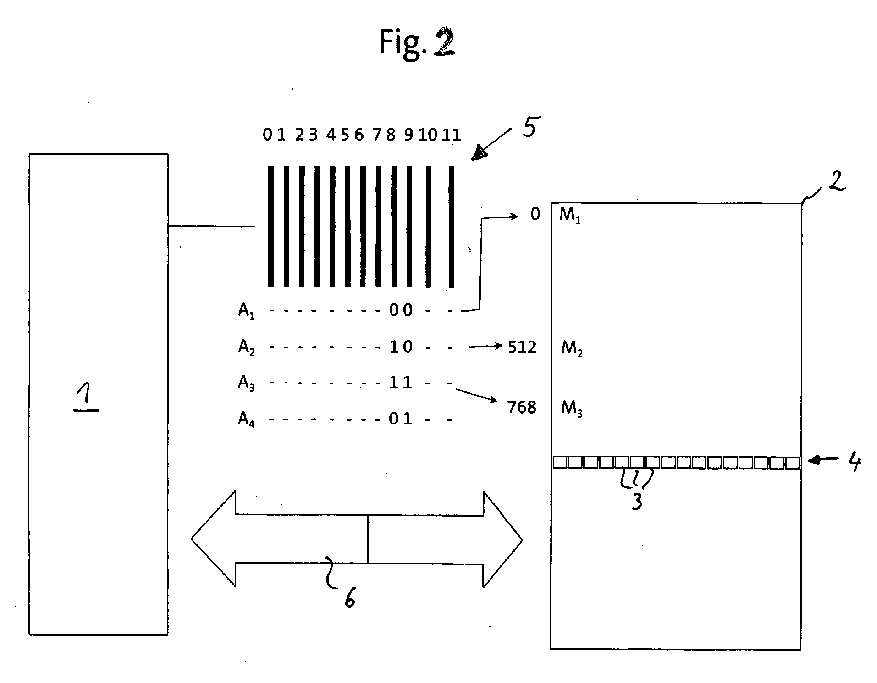

Es ist sodann zu prüfen, ob der Adressbus/-codierer auch hinsichtlich Coupling-Adressfehlern fehlerfrei arbeitet. Dieses Verfahren wird anhand von Fig. 2 erläutert, und zwar anhand des achten und neunten Bits (Bit Nr. 8 und 9) des Adressbuses 5. Mittels des Controllers 1 wird eine erste Adresse A1 adressiert, welche das achte und neunte Bit des Datenbuses jeweils mit dem Wert 0 aufweist. Wenn, was hier beispielhaft vorausgesetzt wird, die übrigen Bits des Adressbuses ebenfalls auf 0 gesetzt sind, dann ergibt sich hieraus eine Adressierung der Zeile 0 der Speicherzellenmatrix 2. In diese wird über den Datenbus 6 ein Bitmuster M1 geschrieben. Es wird sodann vom Controller 1 die Adresse A3 angewählt, bei welcher das achte und neunte Bit des Adressbuses auf 1 gesetzt sind, alle übrigen auf 0. Hieraus ergibt sich die Adressierung der Zeile 768, in die ein Bitmuster M3 geschrieben wird. Dann wird mittels des Controllers 1 eine Adresse A2 angesteuert, in welcher das achte Bit auf 1 und das neunte Bit auf 0 gesetzt sind, die übrigen Bits des Adressbuses sind ebenfalls auf 0 gesetzt, so dass sich in der Speichermatrix 2 die Adressierung der Zeile 512 ergibt, in welche ein Bitmuster M2 geschrieben wird. Alternativ zur Adresse A2 könnte hier auch die Adresse A4 adressiert werden, in welcher das achte Bit auf 0 und das neunte Bit auf 1 gesetzt sind. Dann ergibt sich eine Adresszeile, in die das Bitmuster M2 geschrieben werden kann.

Nachdem die Bitmuster M1, M2 und M3, die sich voneinander unterscheiden müssen, in die Speicherzellenmatrix 2 geschrieben sind, werden durch erneute Adressierung A1, A2, A3 bzw. A4 die entsprechenden Zeilen der Speicherzellenmatrix 2 angewählt und ausgelesen, über den Datenbus 6 dem Controller 1 zugeführt, wo diese mit den ursprünglich geschriebenen Bitmustern M1, M2, M3 verglichen werden. Bei Übereinstimmung der geschriebenen und gelesenen Bitmuster M1 bis M3 ist der Test erfolgreich verlaufen. Er ist dann fortzusetzen, wobei für einen vollständigen Test des Adressbuses/-codierers auf Coupling-Adressfehler jede der zwölf Adressbits mit einem anderen Adressbit wie vorbeschrieben zu kombinieren und dann der vorbeschriebene Test durchzuführen ist.

Für die vollständige Überprüfung auf Coupling-Adressfehler ist der vorstehend beschriebene Test also für die Adressbits 0 und 1, 0 und 2, 0 und 3 bis 0 und 11 durchzuführen, danach für die Adressbits 1 und 2, 1 und 3, 1 und 4 bis 1 und 11, nachfolgend für die Adressbits 2 und 3, 2 und 4, 2 und 5 bis 2 und 11 usw., bis alle Adressbitkombinationen durchgeprüft sind. Bei dem vorstehenden Ausführungsbeispiel ergeben sich somit 198 Adressbitkombinationen, welche mit dem vorbeschriebenen dreifachen Schreib- und Lesetest zu überprüfen sind. Es ist ersichtlich, dass diese Prüfung auch in beliebig anderer Reihenfolge erfolgen kann.

Wenn auch dieser Test abgeschlossen ist, ist der Adressbus/-codierer vollständig überprüft. Es ist ersichtlich, dass die Überprüfung des Adressbuses/-codierers, sei es im Hinblick auf Stuck-at-Adressfehler als auch im Hinblick auf Coupling-Adressfehler, nach dem vorstehend beschriebenen Verfahren beliebig unterbrochen und fortgesetzt werden kann. Entsprechendes gilt für den gesondert davon durchzuführenden Zelltest, bei dem die Speicherzellen 3 selbst überprüft werden.

Für die unabhängig von der Überprüfung des Adressbuses/-codierers vorgesehenen Verfahren zur Überprüfung der Speicherzellen selbst sind gemäß der Erfindung beispielhaft zwei Verfahren vorgesehen.

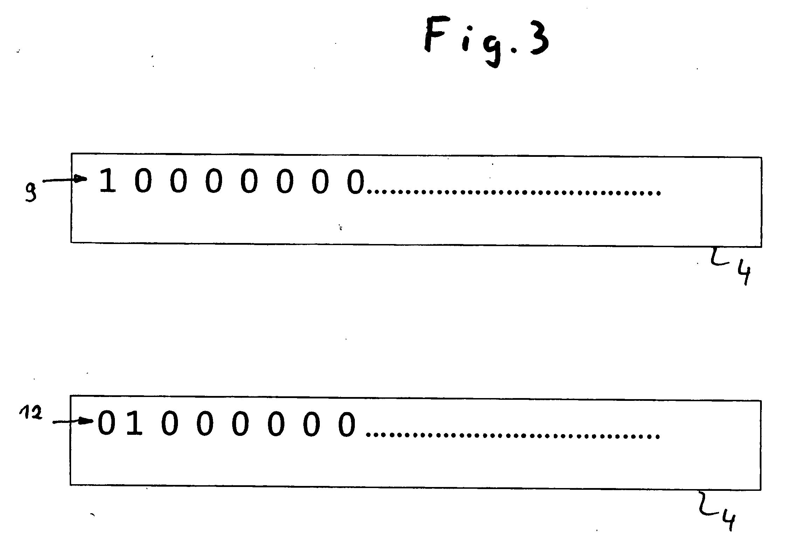

Das anhand von Fig. 3 dargestellte Verfahren arbeitet dergestalt, dass jede einzelne Zelle 3 der Speicherzellenmatrix 2 nacheinander auf 1 gesetzt wird, wobei die übrigen Zellen 3 zumindest derselben Speicherzellenzeile 4 auf 0 gesetzt sind. Der Test beginnt also beispielhaft durch Adressieren der ersten Speicherzellenzeile 4 (in Fig. 2 ist dies die Zeile 0), wonach das erste Bit dieser Speicherzellenzeile auf 1 gesetzt wird, wohingegen alle übrigen Bits auf 0 verbleiben. Dieses Bitmuster 9 wird dann über den Datenbus 6 in die erste Speicherzellenzeile 4 geschrieben und nachfolgend ausgelesen, wobei überprüft wird, ob alle Bits mit Ausnahme des ersten Bits den Wert 0 anzeigen. Es wird dann das zweite Bit in analoger Weise auf 1 gesetzt, wobei alle übrigen Bits den Wert 0 aufweisen, so dass sich das Bitmuster 12 ergibt, das dann in diese Zeile 4 geschrieben und nachfolgend wieder ausgelesen und überprüft wird. Dies setzt sich fort, bis alle Bits einer Zeile, also bei der anhand der Figuren 1 und 2 dargestellten Speicherzellenmatrix 2 alle 16 Bits einer Speicherzellenzeile 4 überprüft worden sind. Dieser Test wird dann Zeile für Zeile fortgesetzt, bis die gesamte Matrix 2 überprüft worden ist. Auch bei diesem Test ist ersichtlich, dass er jederzeit unterbrochen und nach der Unterbrechung wieder fortgesetzt werden kann. Zweckmäßigerweise erfolgt eine Unterbrechung nach Abschluss der Überprüfung einer Zeile 4.

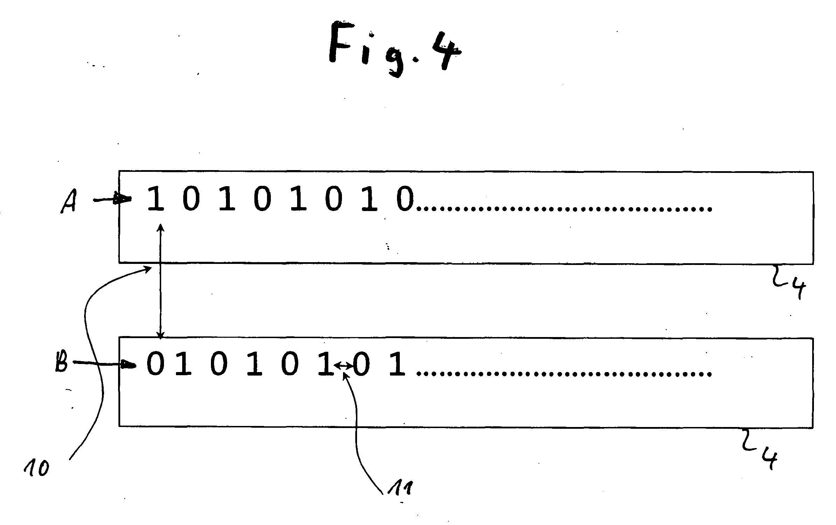

Ein alternatives Verfahren zur Überprüfung der Speicherzellen 3 ist anhand von Fig. 4 beschrieben. Auch hierbei erfolgt der Speicherzellentest zeilenweise, allerdings werden hier sämtliche Zellen 3 einer Zeile 4 praktisch in einem Arbeitsgang überprüft. Es wird in eine Speicherzeile 4 zunächst ein Bitmuster 1 0 1 0 usw. bis zum Ende der Zeile in die Speicherzellenzeile 4 geschrieben. Ein solches Muster A ist in Fig. 4 oben dargestellt. Wie die Figur 4 zeigt, sind die Speicherzellen 3 einer Speicherzeile 4 beginnend mit 1 abwechselnd auf 0 und 1 gesetzt. Es wird dann die gleiche Zeile mit einem inverten Bitmuster B beschrieben, so dass die erste Zelle 3 nun den Wert 0 und die benachbarte Zelle 3 den Wert 1 usw. annimmt, wie dies in Fig. 4 unten dargestellt ist.

Die jeweils nach dem Speichern ausgelesenen Zeilen 4 mit den Bitmustern A und B werden im Controller 1 zwischengespeichert und bitweise verglichen. Dabei wird anhand der ausgelesenen Bitmuster A und B zunächst einmal überprüft, ob in jeder Zelle 3 eine Änderung des Bits von 0 auf 1 bzw. von 1 auf 0 erfolgt ist, wie dies durch den Vergleich 10 in Fig. 4 angedeutet ist. Dieser Test ermittelt Stuck-at-Zellfehler. Darüber hinaus wird anhand des ausgelesenen zweiten Bitmusters B überprüft, ob benachbarte Zellen 3 der ausgelesenen Zeile 4 abwechselnd den Wert 0 und 1 aufweisen oder nicht. Dieser Test ermittelt Coupling-Zellfehler.

Auch der vorbeschriebene Test wird zeilenweise über die gesamte Matrix 2 durchgeführt, um die Speicherzellenmatrix 2 vollständig auf Zellfehler zu überprüfen. Auch dieser Test kann, wie ohne weiteres ersichtlich ist, vorzugsweise nach Abschluss der Überprüfung einer Zeile 4 unterbrochen und zu gegebener Zeit mit Überprüfung der nächsten Zeile fortgesetzt werden. Auch ist die Reihenfolge der zu überprüfende Zeilen 4 nicht zwingend vorgegeben, sie kann wie vorbeschrieben oder auch beliebig anders gewählt werden.

### Bezugszeichenliste

- 1 -: Controller
- 2 -: Speicherzellenmatrix
- 3 -: Speicherzellen
- 4 -: Speicherzellenzeilen
- 5 -: Adressbus
- 6 -: Datenbus
- 7 -: Bitmuster
- 8 -: Bitmuster
- 9 -: Bitmuster

- A -: Bitmuster
- B -: Bitmuster

- 10 -: Vergleich zur Ermittlung von Stuck-at-Zellfehlern
- 11 -: Vergleich zur Ermittlung von Coupling-Zellfehlern
- 12 -: Bitmuster

## Patentansprüche

1. Verfahren zum Prüfen eines Arbeitsspeichers der Steuer- und Regelektronik eines Frequenzumrichters, der mindestens eine Matrix von Speicherzellen, Mittel zum Adressieren der Speicherzellenmatrix und einen Schreib/Leseschaltkreis aufweist und bei dem während des Betriebs des Frequenzumrichters in einem Schritt zumindest ein Teil der Speicherzellen auf Zellfehler überprüft wird, **dadurch gekennzeichnet, dass** während des Betriebs des Frequenzumrichters in einem anderen Schritt zumindest ein Teil der Mittel zum Adressieren auf Adressfehler hin überprüft wird, wobei die Prüfschritte zur Speicherzellen-Überprüfung und Adressiermittel-Überprüfung zeiflich unabhängig voneinander erfolgen und wobei die Adressiermittel-Überprüfung einzelner Adressbits eines n-bit weiten Adressbusses je nach Nutzung des Arbeitspeichers zum Betrieb des Frequenzumrichters wiederum in zeitlich voneinander unabhängigen Prüfschritten erfolgt.

2. Verfahren nach Anspruch 1, **dadurch gekennzeichnet, dass** nach dem Überprüfen eines Teils der Mittel zum Adressieren auf Adressfehler ein Teil der Speicherzellen auf Zellfehler überprüft wird, wonach ein weiterer Teil der Mittel zum Adressieren auf Adressfehler und dann der weitere Teil der Speicherzellen auf Zellfehler und so weiter überprüft wird.

3. Verfahren nach einem der vorhergehenden Ansprüche, **dadurch gekennzeichnet, dass** die Mittel zum Adressieren zunächst auf Adressfehler und nachfolgend die Speicherzellen auf Zellfehler hin überprüft werden.

4. Verfahren nach einem der vorhergehenden Ansprüche, **dadurch gekennzeichnet, dass** das Verfahren zum Prüfen des Arbeitsspeichers in vorbestimmten zeitlichen Abständen wiederholt wird.

5. Verfahren nach einem der vorhergehenden Ansprüche, **dadurch gekennzeichnet, dass** das Verfahren zum Prüfen des Arbeitsspeichers während des Betriebs der mit dem Speicher arbeitenden Einrichtung, insbesondere des Frequenzumrichters, nur dann ausgeführt wird, wenn der das Verfahren ausführende Controller für andere Operationen der Einrichtung nicht benötigt oder vermindert benötigt wird und für das Prüfverfahren freie Kapazitäten hat.

6. Verfahren nach Anspruch 5, **dadurch gekennzeichnet, dass** es zeitweise unterbrochen und anschließend fortgesetzt wird.

7. Verfahren nach einem der vorhergehenden Ansprüche, **dadurch gekennzeichnet, dass** in dem einen Schritt stuck-at-Adressfehler und/oder coupling-Adressfehler ermittelt werden.

8. Verfahren nach einem der vorhergehenden Ansprüche, **dadurch gekennzeichnet, dass** zur Ermittlung von stuck-at-Adressfehlern ein Adressbit der n-Bits des Adressbuses von 0 auf 1 und dann von 1 auf 0 unter Beibehaltung des Zustands der übrigen Adressbits gesetzt wird, dass nach jedem Setzen des einen Adressbits jeweils unterschiedliche Bitmuster in die durch die jeweilige Adressierung angesprochene Speicherzeile geschrieben werden und dass nach dem Schreiben beider Speicherzeilen diese ausgelesen und auf Übereinstimmung mit den zuvor geschriebenen Bitmustern überprüft werden.

9. Verfahren nach Anspruch 8, **dadurch gekennzeichnet, dass** es für jedes der n-Bits des Adressbuses durchgeführt wird.

10. Verfahren nach Anspruch 8 oder 9, **dadurch gekennzeichnet, dass** das in die jeweilige Speicherzeile geschriebene Bitmuster die binäre Adresse der zugehörigen Speicherzeile beinhaltet oder dieser entspricht.

11. Verfahren nach einem der vorhergehenden Ansprüche, **dadurch gekennzeichnet, dass** zur Ermittlung von coupling-Adressfehlern nacheinander jeweils zwei Bits der n-Bits des Adressbuses des Speichers auf 00, auf 11 und auf 01 oder 10 vorzugsweise unter Beibehaltung des Zustands der übrigen Bits gesetzt werden, dass nach jedem Setzen ein unterschiedliches Bitmuster in die durch die jeweilige Adressierung angesprochene Speicherzeile geschrieben wird und dass nach dem Schreiben der Bitmuster in die drei adressierten Zeilen diese ausgelesen und mit den zuvor geschriebenen Bitmustern auf Übereinstimmung geprüft werden.

12. Verfahren nach Anspruch 11, **dadurch gekennzeichnet, dass** jedes Bit der n-Bit des Adressbuses mit jedem der übrigen Bits gesetzt und überprüft wird.

13. Verfahren nach Anspruch 11 oder 12, **dadurch gekennzeichnet, dass** das in die jeweilige Zeile geschriebene Bitmuster die zugehörige binäre Adresse beinhaltet oder dieser entspricht.

14. Verfahren nach einem der vorhergehenden Ansprüche, **dadurch gekennzeichnet, dass** in dem anderen Schritt Zellfehler ermittelt werden, indem benachbarte Speicherzellen einer Speicherzeile abwechselnd mit 0 und 1 beschrieben, ausgelesen und auf Übereinstimmung mit den zuvor geschriebenen Werten überprüft werden, wonach eine umgekehrte Beschreibung mit 1 und 0, Auslesung und Überprüfung erfolgt.

15. Verfahren nach einem der vorhergehenden Ansprüche, **dadurch gekennzeichnet, dass** in dem anderen Schritt Zellfehler ermittelt werden, indem nacheinander jede einzelne Speicherzelle einer Speicherzeile mit 1 und die übrigen mit 0 beschrieben, ausgelesen und überprüft werden.

16. Verfahren nach einem der vorhergehenden Ansprüche, **dadurch gekennzeichnet, dass** mindestens ein in die Speicherzellmatrix geschriebnes und/oder aus dieser ausgelesenes Bitmuster im Controller gespeichert wird.

17. Pumpenaggregat mit einem Frequenzumrichter und einem Motor wobei der Frequenzumrichter den Motor steuerd, mit einer Steuer- und Regelelektronik, die einen Arbeitsspeicher und einen Controller aufweist, wobei der Controller Konfiguriert ist mit einem Verfahren nach einem der vorangehenden Ansprüche den Arbeitspeicher selbsttätig zu überprüben.

## Claims

1. A method for testing a working memory of the control and regulation electronics of a frequency converter which comprises at least one matrix of memory cells, means for addressing the memory cell matrix and a write/read circuit and with which, during the operation of the frequency converter, in one step at least a part of the memory cells is examined with regard to cell errors, **characterised in that** during the operation of the frequency converter, in another step at least a part of the means for addressing is examined with regard to address errors, wherein the testing steps for the memory cell examination and the addressing means examination are effected independently of one another with regard to time, and wherein the addressing means examination of individual address bits of an n-bit wide address bus, depending on the use of the working memory for operation of the frequency converter, is again effected in test steps which are independent of one another with regard to time

2. A method according to claim 1, **characterised in that** after the examination of a part of the means for addressing with regard to address errors, a part of the memory cells is examined with regard to cell errors, whereupon a further part of the means for addressing is examined with regard to address errors and then the further part of the memory cells is examined with regard to cell errors and so on.

3. A method according to one of the preceding claims, **characterised in that** the means for addressing are firstly examined with regard to address errors and subsequently the memory cells are examined with regard to cell errors

4. A method according to one of the preceding claims, **characterised in that** the method for examining the working memory is repeated in predefined temporal intervals.

5. A method according to one of the preceding claims, **characterised in that** the method for testing the working memory during the operation of the device operating with the memory, in particular of the frequency converter, is only carried out if the controller carrying out the method is not required for other operations of the device or is required to a reduced extent and has free capacity for the testing method.

6. A method according to claim 5, **characterised in that** it is temporally interrupted and subsequently continued.

7. A method according to one of the preceding claims, **characterised in that** stuck-at address errors and/or coupling address errors are determined in the one step.

8. A method according to one of the preceding claims, **characterised in that** for determining stuck-at address errors, an address bit of the n-bits of the address bus is set from 0 to 1 and then from 1 to 0 whilst retaining the condition of the remaining address bits, that after each setting of the one address bit, in each case different bit patterns are written into the memory line which is approached by the respective addressing and that after writing both memory lines, these are read out and are examined with regard to agreement with the previously written bit patterns.

9. A method according to claim 8, **characterised in that** it is carried out for each of the n-bits of the address bus.

10. A method according to claim 8 or 9, **characterised in that** the bit pattern which is written into the respective memory line contains the binary address of the associated memory line or corresponds to this.

11. A method according to one of the preceding claims, **characterised in that** for determining coupling address errors, one after the other, in each case two bits of the n-bits of the address bus of the memory are set to 00, to 11 and to 01 or 10, preferably whilst retaining the condition of the remaining bits, that after each setting, a different bit pattern is written into the memory line approached by the respective addressing and that after writing the bit patterns into the three addressed lines, these are read out and examined with regard to agreement with the previously written bit patterns.

12. A method according to claim 11, **characterised in that** each bit of the n-bits of the address bus is set with each of the remaining bits and examined.

13. A method according to claim 11 or 12, **characterised in that** the bit pattern written into the respective line contains the associated binary address or correspond to this.

14. A method according to one of the preceding claims, **characterised in that** in the other step cell errors are determined by way of adjacent memory cells of a memory line being alternatingly written with 0 and 1, read out and examined with regard to agreement with the previously written values, whereupon a reverse writing with 1 and 0, reading-out and examining is effected.

15. A method according to one of the preceding claims, **characterised in that** in the other step, cell errors are determined by way of each individual memory cell of a memory line, one after the other, being written with 1 and the remaining with 0, read out and examined.

16. A method according to one of the preceding claims, **characterised in that** at least one bit pattern which is written into the memory cell matrix and/or is read out of this, is stored in the controller.

17. A pump assembly with a frequency converter and with a motor, wherein the frequency converter controls the motor, with control and regulation electronics which comprise a working memory and a controller, wherein the controller is configured to automatically examine the working memory with a method according to one of the preceding claims.

## Revendications

1. Procédé pour tester une mémoire centrale d'un dispositif électronique de commande et de régulation d'un convertisseur de fréquence qui comprend au moins une matrice de cellules de mémoire, des moyens pour adresser la matrice de cellules de mémoire et un circuit d'écriture/lecture, et dans lequel, pendant le fonctionnement du convertisseur de fréquence, lors d'une étape, au moins une partie des cellules de mémoire est contrôlée pour trouver d'éventuelles erreurs de cellule, **caractérisé en ce que**, pendant le fonctionnement du convertisseur de fréquence, lors d'une autre étape, au moins une partie des moyens d'adressage est contrôlée pour trouver d'éventuelles erreurs d'adresse, les étapes de test destinées à contrôler les cellules de mémoire et destinées à contrôler les moyens d'adressage s'effectuant indépendamment les unes des autres dans le temps et le contrôle des moyens d'adressage des différents bits d'adresse d'un bus d'adresses de n bits s'effectuant en fonction de l'utilisation de la mémoire centrale pour le fonctionnement du convertisseur de fréquence, cette fois encore lors d'étapes de contrôle indépendantes les unes des autres dans le temps.

2. Procédé selon la revendication 1, **caractérisé en ce qu'**après le contrôle d'une partie des moyens d'adressage pour trouver d'éventuelles erreurs d'adresse, on contrôle une partie des cellules de mémoire pour trouver d'éventuelles erreurs de cellule, après quoi une autre partie des moyens d'adressage est contrôlée pour trouver d'éventuelles erreurs d'adresse, puis l'autre partie des cellules de mémoire est contrôlée pour trouver d'éventuelles erreurs de cellule, et ainsi de suite.

3. Procédé selon l'une des revendications précédentes, **caractérisé en ce que** les moyens d'adressage sont tout d'abord contrôlés pour trouver d'éventuelles erreurs d'adresse, puis les cellules de mémoire sont contrôlées pour trouver d'éventuelles erreurs de cellule.

4. Procédé selon l'une des revendications précédentes, **caractérisé en ce que** le procédé pour tester la mémoire centrale est répété à des intervalles de temps prédéterminés.

5. Procédé selon l'une des revendications précédentes, **caractérisé en ce que** le procédé pour tester la mémoire centrale, pendant le fonctionnement de l'installation travaillant avec la mémoire, en particulier du convertisseur de fréquence, est exécuté uniquement lorsque le contrôleur exécutant le procédé n'est pas occupé, ou n'est occupé qu'à un taux réduit, pour d'autres opérations du dispositif et qu'il dispose de capacités libres pour le procédé de test.

6. Procédé selon la revendication 5, **caractérisé en ce qu'**il est interrompu temporairement, puis repris.

7. Procédé selon l'une des revendications précédentes, **caractérisé en ce que**, dans une étape, on détermine des erreurs d'adresse de type blocage et/ou des erreurs d'adresse de type couplage.

8. Procédé selon l'une des revendications précédentes, **caractérisé en ce que**, pour déterminer des erreurs d'adresse de type blocage, un bit d'adresse des n bits du bus d'adresses est positionné de 0 à 1, puis de 1 à 0 en laissant inchangé l'état des autres bits d'adresses, **en ce qu'**après chaque paramétrage d'un bit d'adresse, à chaque fois les différents profils binaires sont écrits dans la ligne de mémoire adressée par l'adressage respectif et **en ce que**, après l'écriture des deux lignes de mémoire, celles-ci sont lues et vérifiées pour la concordance avec les profils binaires écrits précédemment.

9. Procédé selon la revendication 8, **caractérisé en ce qu'**il est exécuté pour chacun des n bits du bus d'adresses.

10. Procédé selon la revendication 8 ou 9, **caractérisé en ce que** le profil binaire écrit dans la ligne de mémoire respective contient l'adresse binaire de la ligne de mémoire correspondante ou correspond à celle-ci.

11. Procédé selon l'une des revendications précédentes, **caractérisé en ce que**, pour déterminer des erreurs d'adresse de type couplage, à chaque fois, deux bits des n bits du bus d'adresses de la mémoire sont positionnés l'un après l'autre sur 00, sur 11 et sur 01 ou sur 10, de préférence en laissant inchangé l'état des autre bits, **en ce qu'**après chaque paramétrage, un profil binaire différent est écrit dans la ligne de mémoire adressée par l'adressage respectif et **en ce qu'**après l'écriture du profil binaire dans les trois lignes adressées, ces dernières sont lues et vérifiées pour leur concordance avec les profils binaires écrits précédemment.

12. Procédé selon la revendication 11, **caractérisé en ce que** chacun des n bits du bus d'adresse est paramétré avec chacun des bits restants et contrôlé.

13. Procédé selon la revendication 11 ou 12, **caractérisé en ce que** le profil binaire écrit dans la ligne respective contient l'adresse binaire correspondante ou correspond à celle-ci.

14. Procédé selon l'une des revendications précédentes, **caractérisé en ce que**, dans l'autre étape, des erreurs de cellule sont déterminées par le fait que des cellules de mémoire voisines d'une ligne de mémoire sont déclarées alternativement avec 0 et 1, lues et leur concordance avec les valeurs écrites précédemment vérifiée, après quoi une déclaration inversée avec 1 et 0, une lecture et un contrôle sont réalisés.

15. Procédé selon l'une des revendications précédentes, **caractérisé en ce que**, dans l'autre étape, des erreurs de cellule sont déterminées par le fait que, successivement, chaque cellule de mémoire distincte d'une ligne de mémoire est déclarée avec 1 et les autres avec 0, lue et vérifiée.

16. Procédé selon l'une des revendications précédentes, **caractérisé en ce qu'**au moins un profil binaire écrit dans la matrice de cellules de mémoire et/ou lu à partir de celle-ci est mémorisé dans le contrôleur.

17. Groupe pompe comprenant un convertisseur de fréquence et un moteur, le convertisseur de fréquence commandant le moteur, avec un dispositif électronique de commande et de régulation qui comprend une mémoire centrale et un contrôleur, le contrôleur étant configuré pour tester automatiquement la mémoire centrale avec un procédé selon l'une des revendications précédentes.
